# EUROPEAN PATENT SPECIFICATION

(11) **EP 1 190 568 B1**
(45) Date of publication and mention of the grant of the patent: **04.04.2012**
(21) Application number: 01907503.5
(22) Date of filing: 07.02.2001
(51) Int. Cl.: H03G 3/30, H04N 5/60, H04N 5/44

(54) **AUTOMATIC GAIN CONTROL**
AUTOMATISCHE VERSTÄRKUNGSREGELUNG
REGLAGE D'AMPLIFICATION AUTOMATIQUE

(30) Priority: 08.02.2000 WO PCT/SG00/00018; 27.03.2000 SG 200001748
(43) Date of publication of application: 27.03.2002
(73) Proprietor: NXP B.V., 5656 AG Eindhoven (NL)
(72) Inventor: YEO, Alan, C., L., NL-5656 AA Eindhoven (NL); KWONG, Kam, C., NL-5656 AA Eindhoven (NL); PANG, Mieu, N., NL-5656 AA Eindhoven (NL); TAN, Hwee, B., NL-5656 AA Eindhoven (NL)
(74) Representative: Small, Gary James
(86) International application number: PCT/EP2001/001277
(87) International publication number: WO 2001/060056

(56) References cited:
- EP-A- 0 470 504
- EP-A- 0 472 119
- EP-A- 0 512 374

## Description

The invention relates to a method and device for automatic gain control in receivers for both TV and FM radio.

WOA-94/06244 discloses a variable gain amplifier. Front-end portions of television receivers or video tape recorders are described, each of which uses separate intermediate-frequency (IF) amplifiers for the FM sound carrier and vestigial AM picture carrier. In each front end, the two IF amplifiers comprise matched cascade connections of the variable gain amplifiers with tracking automatic gain control (AGC). The AGC signals are generated by an AGC detector supplied composite video signal from a video detector, which video detector responds to amplified IF signal supplied by the IF amplifier for the vestigial AM picture carrier. This apparatus is not suitable for a receiver for both TV and FM radio, as in FM radio receipt mode the video detector does not receive TV signals on which AGC control signals can be based.

US-A-5,144,439 discloses a mono FM radio in a television receiver which includes a single tuner for tuning both television signals and broadcast FM stations. The tuner is operated at a fixed gain setting in FM reception mode.

It is, inter alia, an object of the invention to provide an automatic gain control for both TV reception and FM radio reception. To this end, the invention provides an automatic gain control as defined in the independent claims. Advantageous embodiments are defined in the dependent claims.

In a method of automatic gain control for both TV and FM radio signals, the TV and FM radio signals are controllably amplified to obtain amplifier output signals, the amplifier output signals are tuner processed to obtain tuner output signals, the tuner output signals are applied as control signals to the controllable amplifier, a bandwidth of a thus formed AGC loop being wide enough for a TV channel, and the tuner output signals are narrow-band filtered to obtain narrow-band filtered signals having a bandwidth substantially corresponding to a bandwidth of an FM radio channel.

These and other aspects of the invention will be apparent from and elucidated with reference to the embodiments described hereinafter. Herein shows:
Figure 1 an embodiment of a receiver in accordance with the present invention, and
Figure 2 a second embodiment of a receiver in accordance with the present invention.

In the drawing, antenna signals from an antenna A are applied to an AGC amplifier AGC-AMP, the output of which is applied to a cascade connection of an IF filter F, a mixer MIX and an IF amplifier IF-AMP. An output of the IF amplifier IF-AMP is applied to a ceramic filter CF having an output connected to an FM sound demodulator IC FM Snd Dem. A sound processor Snd Proc processes output signals of the FM sound demodulator IC FM Snd Dem to furnish (stereo) load-speaker signals to load-speakers L. The output of the IF amplifier IF-AMP is also applied to a surface acoustic wave filter SAW having an output that is connected to a TV IF IC. A TV processor TV Proc processes output signals of the TV IF IC to furnish (color) image signals to a TV display TVD.

The output of the IF amplifier IF-AMP is fed back to the AGC amplifier AGC as a tuner-internal AGC signal T-AGC. Optionally, a conventional AGC signal TV-AGC from the TV IF IC is also applied as a control signal to the AGC amplifier AGC. Optionally, an FM AGC signal from the FM sound processor IC FM Snd Proc is also applied as a control signal to the AGC amplifier AGC.

During FM radio reception, protection of the mixer MIX and IF amplifier IF-AMP is needed is needed because of the varying strength and proximity of adjacent FM channels. Adjacent FM channels are 200 kHz apart as compared to 6, 7 or 8 MHz for TV. Since the RF bandwidth during FM reception is in the order of a few MHz, a wide-band predetermined AGC or software-selectable AGC is provided. The bandwidth of this wide-band AGC is wide enough to cope with TV signals (intended for the TV IF IC). This wide-band AGC peeks at the IF before the ceramic filter CF that has a typical bandwidth of 200 kHz and based on a predetermined level decides to act or not. This prevents the tuner stages from overloading.

The proposed tuner-internal wide-band AGC can be used together with the conventional TV AGC or instead of the conventional TV AGC.

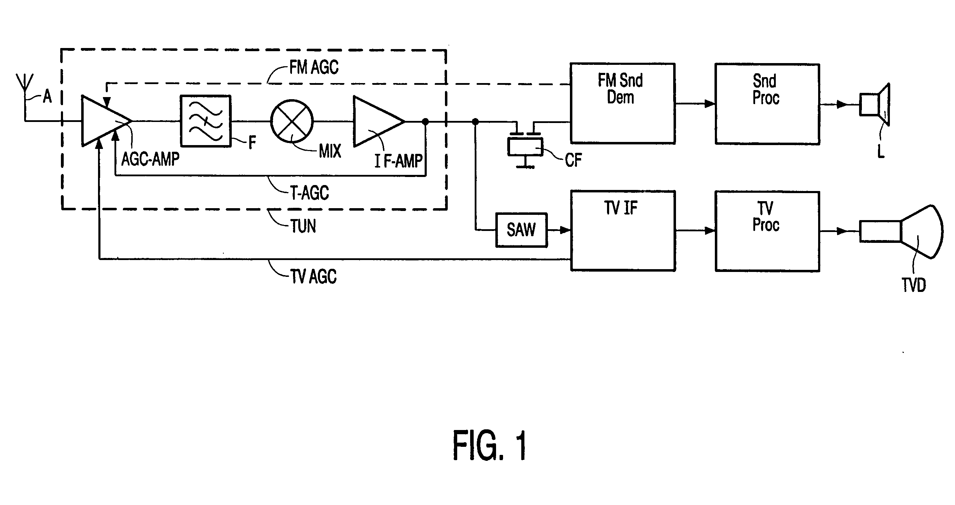

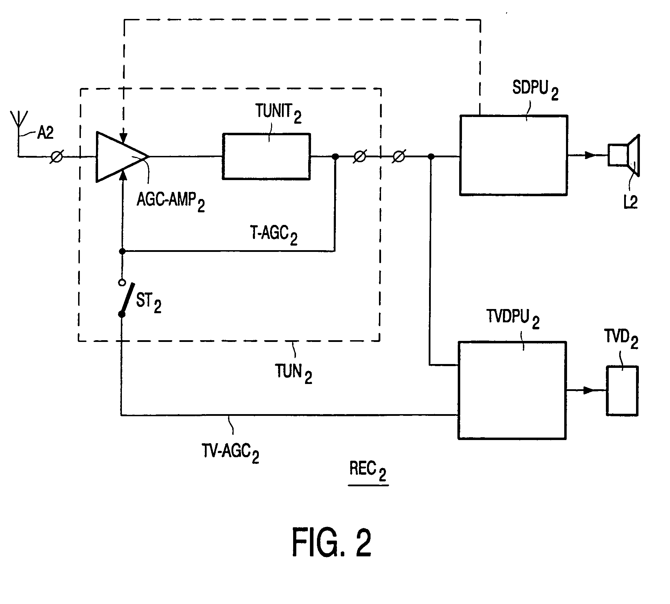

Figure 2 shows a second embodiment of a receiver REC2 in accordance with the present invention. The same elements as in figure 1 are denoted with corresponding reference numerals.

Antenna signals from an antenna A2 are applied to an AGC amplifier AGC-AMP2, the output of which is applied to a tuner unit TUNIT2. The tuner unit TUNIT2 comprises for example the IF filter, mixer and IF amplifier as shown in figure 1. The output of the tuner unit UNIT2 is coupled to the output of the tuner TUN2 for supplying to both the sound demodulation and processing unit SDPU2 and the TV demodulation and processing unit TVDPU2 the output signals.

These two units are only given block schematic and can for example comprise the same elements as the corresponding parts in figure 1. The output of the sound demodulation and processing unit SDPU2 is coupled to loudspeakers L2 and the output of the TV demodulation and processing unit TVDPU2 is coupled to a TV display TVD2.

The TV demodulation and processing unit TVDPU2 comprises further a control output for supplying a control signal TVAGC2 corresponding to the control signal as described in relation to figure 1. This control signal is supplied to the tuner TUN2 to be a control signal for the AGC amplifier AGC-AMP2. The AGC amplifier further receives an internal control signal TAGC2 which is the same or corresponding as in figure 1.

The difference with the tuner of this figure and the tuner TUN of figure 1 is that the control signal from the TV demodulation and processing unit TVDPU2 is now supplied to the AGC amplifier AGC-AMP2 via switching means ST2. This switching means are controlled in such a way that during reception of FM radio signals the switch is open and during receiving TV signals switch is closed. In this way the undefinable output signal of the TV demodulation and processing unit TVDPU2 during reception of FM radio signals have no influence on the AGC amplifier AGC-AMP2. In this way the operation of the tuner and that of the receiver is further improved.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements, and by means of a suitably programmed computer. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of automatic gain control for both TV and FM radio signals, the method comprising the steps of:
controllably amplifying by an automatic gain control amplifier (AGC-AMP) the TV and FM radio signals to obtain amplifier output signals;
tuner processing by a cascade connection of an IF filter (F), a mixer (M:X), and an IF amplifier (IF-AMP) the amplifier output signals to obtain tuner output signals;
filtering by a narrow-band filter (CF) the tuner output signals to obtain narrow-band filtered signals having a bandwidth substantially corresponding to a bandwidth of an FM radio channel;
demodulating by an FM sound demodulator (FM Snd Dem) the narrow-band filtered signals to obtain further control signals (FM-AGC) for the automatic gain control amplifier (AGC-AMP);
processing by image signal processing circuitry (SAW, TV IF) the tuner output signals to obtain further control signals (TV-AGC) for the automatic gain control amplifier (AGC-AMP); and
applying the tuner output signals as automatic gain control signals (T-AGC) to the automatic gain control amplifier (AGGAMP), a bandwidth of a thus formed AGC loop being wide enough for a TV channel,
wherein, during reception of FM radio signals, the further control signals (FM-AGC) from the FM sound demodulator (FM Snd Dem) are applied to the automatic gain control amplifier (AGC-AMP) and, during reception of TV signals, the further control signals (TV-AGC) from the image signal processing circuitry (TV IF) are applied to the automatic gain control amplifier (AGC-AMP).

2. A device for automatic gain control for both TV and FM radio signals, the device comprising:
a controllable amplifier (AGC-AMP) configured to receive the TV and FM radio signals and provide amplifier output signals;
a tuner (TUN) having a cascade connection of an IF filter (F), a mixer (MIX), and an IF amplifier (IF-AMP) configured to process the amplifier output signals and provide tuner output signals;
a narrow-band filter (CF) configured to receive the tuner output signals and provide narrow-band filtered signals having a bandwidth substantially corresponding to a bandwidth of an FM radio channel;
FM sound processing circuitry (FM Snd Dem, Snd Proc) configured to demodulate the narrow-band filtered signals to obtain further control signals (FM-AGC) and to provide loudspeaker signals from the narrow-band filtered signals;
image signal processing circuitry (SAW, TV IF, TV Proc) configured to provide display signals from the tuner output signals and to process the tuner output signals to provide further control signals for the controllable amplifier (AGC-AMP); and
feedback means (T-AGC) configured to apply the tuner output signals as control signals to the controllable amplifier (AGC-AMP), a bandwidth of a thus formed AGC loop being wide enough for a TV channel,
wherein the device is configured, during reception of FM radio signals, to apply the further control signals (FM-AGC) from the FM sound processing circuitry (FM Snd Dem) to the automatic gain control amplifier (AGC-AMP) and, during reception of TV signals, to apply the further control signals (TV-AGC) from the image signal processing circuitry (TV IF) to the automatic gain control amplifier (AGC-AMP).

3. A receiving apparatus as claimed in claim 2 further comprising:
switching means (ST₂) configured to couple the further control signals from the image signal processing circuitry to the controllable amplifier during reception of TV signals.

4. A display apparatus comprising:
a receiving apparatus as claimed in claim 2; and
an image display (TV) configured to display the display signals.

## Patentansprüche

1. Verfahren zur automatischen Verstärkungsregelung für sowohl TV- als auch FM-Funksignale, wobei das Verfahren die folgenden Schritte aufweist:
regelbares Verstärken der TV- und FM-Funksignale durch einen automatischen Verstärkungsregelungsverstärker (AGC-AMP) zum Erhalten von Verstärkerausgangssignalen;
Abstimmvorrichtungsverarbeitung der Verstärkerausgangssignale durch eine Kaskadenschaltung eines ZF-Filters (F), eines Mischers (MIX) und eines ZF-Verstärkers (IF-AMP) zum Erhalten von Abstimmvorrichtungsausgangssignalen;
Filtern der Abstimmvorrichtungsausgangssignale durch einen Schmalbandfilter (CF) zum Erhalten von schmalbandgefilterten Signalen, die eine Bandbreite aufweisen, die im Wesentlichen einer Bandbreite eines FM-Funkkanals entspricht;
Demodulieren der schmalbandgefilterten Signale durch einen FM-Tondemodulator (FM Snd Dem) zum Erhalten weiterer Regelsignale (FM-AGC) für den automatischen Verstärkungsregelungsverstärker (AGC-AMP);
Verarbeiten der Abstimmvorrichtungsausgangssignale durch Bildsignal-Verarbeitungsschaltungen (SAW, TV IF) zum Erhalten weiterer Regelsignale (TV-AGC) für den automatischen Verstärkungsregelungsverstärker (AGC-AMP); und
Anlegen der Abstimmvorrichtungsausgangssignale als automatische Verstärkungsregelungssignale (T-AGC) an den automatischen Verstärkungsregelungsverstärker (AGC-AMP), wobei eine Bandbreite einer so gebildeten AGC-Schleife breit genug für einen TV-Kanal ist,
wobei während des Empfangs von FM-Funksignalen die weiteren Regelsignale (FM-AGC) von dem FM-Tondemodulator (FM Snd Dem) an den automatischen Verstärkungsregelungsverstärker (AGC-AMP) angelegt werden und während des Empfangs von TV-Signalen die weiteren Regelsignale (TV-AGC) von den Bildsignal-Verarbeitungsschaltungen (TV IF) an den automatischen Verstärkungsregelungsverstärker (AGC-AMP) angelegt werden.

2. Einrichtung zur automatischen Verstärkungsregelung für sowohl TV- als auch FM-Funksignale, wobei die Einrichtung Folgendes umfasst:
einen regelbaren Verstärker (AGC-AMP), der konfiguriert ist, um die TV- und FM-Funksignale zu empfangen und Verstärkerausgangssignale bereitzustellen;
eine Abstimmvorrichtung (TUN), die eine Kaskadenschaltung eines ZF-Filters (F), eines Mischers (MIX) und eines ZF-Verstärkers (IF-AMP) aufweist, die konfiguriert ist, um die Verstärkerausgangssignale zu verarbeiten und Abstimmvorrichtungsausgangssignale bereitzustellen;
einen Schmalbandfilter (CF), der konfiguriert ist,
um die Abstimmvorrichtungsausgangssignale zu empfangen und schmalbandgefilterte Signale bereitzustellen, die eine Bandbreite aufweisen,
die im Wesentlichen einer Bandbreite eines FM-Funkkanals entspricht;
FM-Tonverarbeitungsschaltungen (FM Snd Dem, Snd Proc), die konfiguriert sind, um die schmalbandgefilterten Signale zu demodulieren, um weitere Regelsignale (FM-AGC) zu erhalten und
Lautsprechersignale von den schmalbandgefilterten Signalen bereitzustellen;
Bildsignalverarbeitungsschaltungen (SAW, TV IF, TV Proc), die konfiguriert sind, um Anzeigesignale von den Abstimmvorrichtungsausgangssignalen bereitzustellen und die Abstimmvorrichtungsausgangssignale zu verarbeiten,
um weitere Regelsignale für den regelbaren Verstärker (AGC-AMP) bereitzustellen; und
Rückkopplungsmittel (T-AGC), die konfiguriert sind, um die Abstimmvorrichtungsausgangssignale als Regelsignale an den regelbaren Verstärker (AGC-AMP) anzulegen, wobei eine Bandbreite einer so gebildeten AGC-Schleife breit genug für einen TV-Kanal ist,
wobei die Einrichtung während des Empfangs von FM-Funksignalen konfiguriert ist, um die weiteren Regelsignale (FM-AGC) von den FM-Tonverarbeitungsschaltungen (FM Snd Dem) an den automatischen Verstärkungsregelungsverstärker (AGC-AMP) anzulegen und während des Empfangs von TV-Signalen die weiteren Regelsignale (TV-AGC) von den Bildsignal-Verarbeitungsschaltungen (TV IF) an den automatischen Verstärkungsregelungsverstärker
(AGC-AMP) anzulegen.

3. Empfangsvorrichtung nach Anspruch 2, die ferner Folgendes umfasst:
Schaltmittel (ST₂), die konfiguriert sind, um die weiteren Regelsignale von den Bildsignal-Verarbeitungsschaltungen während des Empfangs von TV-Signalen an den regelbaren Verstärker zu koppeln.

4. Anzeigevorrichtung, die Folgendes umfasst:
eine Empfangsvorrichtung nach Anspruch 2; und
eine Bildanzeige (TVD), die konfiguriert ist, um die Anzeigesignale anzuzeigen.

## Revendications

1. Procédé de commande de gain automatique aussi bien pour des signaux TV que pour des signaux radio FM, ce procédé comprenant les étapes consistant à :
amplifier de manière contrôlable avec un amplificateur de commande de gain automatique (AGC-AMP) les signaux TV et radio FM afin d'obtenir des signaux de sortie d'amplificateur ;
traiter par syntoniseur avec une connexion en cascade d'un filtre IF (F), d'un mélangeur (MX), et d'un amplificateur IF (IF-AMP) les signaux de sortie de l'amplificateur afin d'obtenir des signaux de sortie de syntoniseur ;
filtrer avec un filtre à bande étroite (CF) les signaux de sortie du syntoniseur afin d'obtenir des signaux filtrés à bande étroite ayant une largeur de bande correspondant essentiellement à une largeur de bande d'une chaîne radio FM ;
démoduler avec un démodulateur de son FM (FM Snd Dem) les signaux filtrés à bande étroite afin d'obtenir d'autres signaux de commande (FM-AGC) pour l'amplificateur de commande de gain automatique (AGC-AMP) ;
traiter avec une circuiterie de traitement de signaux d'image (SAW, TV IF) les signaux de sortie du syntoniseur afin d'obtenir d'autres signaux de commande (TV-AGC) pour l'amplificateur de commande de gain automatique (AGC-AMP) ; et à
appliquer les signaux de sortie du syntoniseur comme signaux de commande de gain automatique (T-AGC) sur l'amplificateur de commande de gain automatique (AGC-AMP), une largeur de bande d'une boucle AGC ainsi formée étant suffisamment large pour une chaîne TV,
dans lequel, pendant la réception de signaux radio FM, les autres signaux de commande (FM-AGC) venant du démodulateur de sons FM (FM Snd Dem) sont appliqués sur l'amplificateur de commande de gain automatique (AGC-AMP) et, pendant la réception de signaux TV, les autres signaux de commande (TV-AGC) provenant de la circuiterie de traitement de signaux d'image (TV IF) sont appliqués sur l'amplificateur de commande de gain automatique (AGC-AMP).

2. Dispositif pour la commande de gain automatique aussi bien pour des signaux TV que pour des signaux radio FM, ce dispositif comprenant :
un amplificateur contrôlable (AGC-AMP) configuré de façon à recevoir les signaux TV et radio FM et à fournir des signaux de sortie d'amplificateur ;
un syntoniseur (TUN) ayant une connexion en cascade d'un filtre IF (F), d'un mélangeur (MIX) et d'un amplificateur IF (IF-AMP), configuré de façon à traiter les signaux de sortie de l'amplificateur et à fournir des signaux de sortie du syntoniseur ;
un filtre à bande étroite (CF) configuré de façon à recevoir les signaux de sortie du syntoniseur et à fournir des signaux filtrés à bande étroite ayant une largeur de bande correspondant essentiellement à une largeur de bande d'une chaîne radio FM ;
une circuiterie de traitement de sons FM (FM Snd Dem, Snd Proc) configurée de façon à démoduler les signaux filtrés à bande étroite afin d'obtenir d'autres signaux de commande (FM-AGC) et à fournir des signaux de haut-parleur à partir des signaux filtrés à bande étroite ;
une circuiterie de traitement de signaux d'image (SAW, TV IF, TV Proc) configurée de façon à fournir des signaux d'affichage à partir des signaux de sortie du syntoniseur et à traiter les signaux de sortie du syntoniseur afin de fournir d'autres signaux de commande pour l'amplificateur contrôlable (AGC-AMP) ; et
un moyen de réaction (T-AGC) configuré de façon à appliquer les signaux de sortie du syntoniseur comme signaux de commande sur l'amplificateur contrôlable (AGC-AMP), une largeur de bande d'une boucle AGC ainsi formée étant suffisamment large pour une chaîne TV,
ce dispositif étant configuré, pendant la réception de signaux radio FM, de façon à appliquer les autres signaux de commande (FM-AGC) venant de la circuiterie de traitement de sons FM (FM Snd Dem) sur l'amplificateur de commande de gain automatique (AGC-AMP) et, pendant la réception de signaux TV, de façon à appliquer les autres signaux de commande (TV-AGC) venant de la circuiterie de traitement de signaux d'image (TV IF) sur l'amplificateur de commande de gain automatique (AGC-AMP).

3. Appareil de réception selon la revendication 2, comprenant en outré :
un moyen de commutation (ST₂) configuré de façon à coupler les autres signaux de commande provenant de la circuiterie de traitement de signaux d'image à l'amplificateur contrôlable pendant la réception de signaux TV.

4. Appareil d'affichage comprenant :
un appareil de réception selon la revendication 2 ; et
un affichage d'images (TVD) configuré de façon à afficher les signaux d'affichage.
